# EUROPEAN PATENT SPECIFICATION

(11) **EP 3 035 533 B1**
(45) Date of publication and mention of the grant of the patent: **16.10.2019**
(21) Application number: 14197907.0
(22) Date of filing: 15.12.2014
(51) Int. Cl.: H03K 17/28, H03K 3/57, H01H 47/32

(54) **Switching circuit for a door opener of an electrical appliance and electrical appliance**
Schaltkreis für einen Türöffner eines elektrischen Geräts sowie elektrisches Gerät
Circuit de commutation de dispositif d'ouverture de porte d'un appareil électrique et appareil électrique

(43) Date of publication of application: 22.06.2016
(73) Proprietor: E.G.O. Elektro-Gerätebau GmbH, 75038 Oberderdingen (DE)
(72) Inventor: Manan, Jose Antonio, 08110 Montcada i Reixac (ES)
(74) Representative: Patentanwälte Ruff, Wilhelm, Beier, Dauster & Partner mbB

(56) References cited:
- GB-A- 1 425 003
- GB-A- 1 604 582
- GB-A- 2 196 500
- LU-A1- 43 315

## Description

### Technical field and prior art

The invention relates to an electrical appliance with a door, such as a washing machine or a dryer.

Door openers for electrical appliances such as washing machines are commonly known, for example from WO 2009/012965 A1. An actuator for opening the door when the user needs or wishes to may be an electromechanical system including solenoid means and a shaft connected to the solenoid means for pushing the door to unlock the mechanical locking system. Safety is especially sensitive during operation of a washing machine, since an accidentally opened door may provoke a dangerous situation, for example when the washing machine is spinning with high speed or washing with 90 °C water. Current safety regulations require a door opener to be robust to two consecutive failures, or one failure if this is recognized by the system.

Further switching circuits for such door openers of electrical appliances are known from DE 2163449 A1 and GB 1604582 A.

From GB 2 196 500 A a control circuit is known for energizing current to a coil of a gas valve solenoid of a magnetic gas valve. After a predetermined delay a predetermined energizing current is provided to the coil for a predetermined period. A capacitor is provided being connected in series with a resistor across a power supply and in parallel to a switch. The switch is closed when the voltage across the capacitor exceeds a predetermined voltage. This appliance is a gas-consuming appliance such as a boiler for heating water.

From LU 43 315 A1, another control circuit is known for controlling a solenoid of a relay.

From GB 1 425 003 A, another control circuit as a time delay device is known for controlling a relay.

### Object and solution

It is an object of the invention to provide an electrical appliance that provides for a safe operation, especially with regard to locking or unlocking a door, and that is cost-effective and robust in manufacture as well as operation.

This object is achieved by an electrical appliance having the features of claim 1. Advantageous and preferred embodiments of the invention are defined in the further claims and are described in more detail in the following. The content of the claims is made an integral part of the description by explicit reference.

The switching circuit of the electrical appliance comprises a solenoid means for mechanically opening or unlocking the door of the electrical appliance. In their deactivated state they preferably lock the door, and only after activation they can open or unlock the door after the door has been manually closed for operation of the electrical appliance. The solenoid means may preferably be coupled with an aforementioned actuator of a door lock mechanism. However, this is known to a person skilled in the art and consequently only the solenoid means are described here in detail.

The switching circuit also comprises a DC voltage converter that is coupled to an AC mains, for example directly to an AC mains of a house or of a switching power supply of the electrical appliance itself. The DC voltage converter finally serves for actuating the solenoid means, whereas they are not directly coupled with each other. Furthermore, a first switching means and a second switching means are provided, preferably for triggering an actuation of the solenoid means. Basically, during operation of the electrical appliance, the switching means prevent an actuation of the solenoid means. Only if the door shall be opened by a user and if safety rules are complied with shall the switching means trigger an actuation of the solenoid means for opening or unlocking the door. The same circuit can be used for a double mechanical door opener actuator.

A series circuit is provided having a capacitor, a resistor and the second switching means, wherein this series circuit is connected to an output of the DC voltage converter. This means that this series circuit is connected to the full voltage of the converter. The solenoid means and a voltage-controlled switch are provided in parallel to the capacitor, preferably in parallel to only the capacitor. This obviously serves for providing the current for triggering actuation of the solenoid means not directly from the DC voltage converter, but from the capacitor.

Basically, the invention provides for an energizing of the solenoid means by the capacitor, which means limited current or energy, respectively. This protects the solenoid means. Furthermore, the solenoid means have a constant energizing voltage and/or fixed energy from the capacitor, which is not depending on the AC mains tolerances. A maximum current through the solenoid means is also limited when provided by the capacitor. Also an inrush current in the solenoid means or a coil being part of the solenoid means is decoupled from the AC mains. The solenoid means do also not have to support the full DC voltage directly. Instead, the capacitor starts charging through the resistor increasing a voltage across it slowly. When a given voltage is reached, the voltage-controlled switch switches on automatically and discharges the energy of the capacitor in a single short high energy pulse to the solenoid means, which are energized by this and triggered into action.

In an embodiment of the invention, a signal output for a first feedback signal that may be given to a control of the electrical appliance or to a control of the switching circuit may be provided between the solenoid means and the above-mentioned capacitor.

In a further embodiment, a signal output for a second feedback signal may be provided between the second switching means and the resistor, respectively. Also this second feedback signal is given to a control of the electrical appliance. By using these two feedback signals, or even only one of them, an accidental activation of the first switching means or the second switching means may be prevented. They also serve to detect a failure of one of the first or the second switching means.

The first switching means may be provided before the DC voltage converter or between the AC mains and the DC voltage converter. This provides for a potential total cutout of the voltage converter when the first switching means are open or shorted, respectively. This means that for example the first switching means must be activated or closed before any actuation of the solenoid means is possible. If the electrical appliance is a washing machine, the first switching means may for example be coupled to the motor or a tachometer controlling rotation of the washing drum. If the washing drum is rotating, the first switching means are open and the whole switching circuit with the DC voltage converter is not even energized.

The second switching means may be connected directly to the DC voltage converter on the one hand and to the resistor in the series circuit on the other hand.

The capacity of the capacitor and the resistance of the resistor are chosen such that the charging time for charging the capacitor up to a voltage that corresponds to the activating voltage of the voltage-controlled switch may be between 2 seconds and 20 seconds or even 30 seconds. This time is an approximate value and can also be less than 2 seconds or more than 20 seconds. A preferred charging time may last from 3 seconds to 5 or 8 seconds. This means that after accidentally activating or closing one of the switching means as described before, the time span after a deactivation of the other switch is between 3 seconds and 8 seconds, providing the required safety.

In a further embodiment of the invention, the resistance of the resistor is calculated as to block the energization of the solenoid means if the voltage-controlled switch is short-cut when taking into consideration the impedance of the solenoid means. This means that if the voltage-controlled switch is short-cut, only if the capacitor is charged up to a voltage that activates the voltage-controlled switch or exceeds its activation voltage then, in this case, the current flows from the capacitor through the solenoid means for their activation. Discharging the capacitor to the solenoid means for their activation starts automatically, as soon as the activation voltage of the voltage-controlled switch is exceeded.

A duration of the pulse discharge of the capacitor to the solenoid means may be between 0.1 seconds and 1 second, preferably between 0.2 seconds and 0.4 seconds. This means that the capacitor is discharged relatively quickly.

Furthermore, the switching means may be connected, preferably together with the above-mentioned feedback signals, with a bus or a bus controller of a control of the electrical appliance. This bus is preferably also connected to the feedback signals. Such a bus and bus controller may also be provided with an activating signal by a user of the electrical appliance if the door is to be opened.

These and further features can be gathered not only from the claims but also from the description and the drawings, wherein the individual features can in each case be realized on their own or several combined together in an embodiment of the invention and in other areas and can constitute advantageous and independently patentable configurations for which protection is claimed here. Subdividing the application into sub-headings and individual sections does not restrict the general validity of what is said therebeneath or therein.

### Short description of the drawings

Embodiments of the invention are depicted in the drawings and are described hereinafter in greater detail. In the drawings show:
- Fig. 1: a schematically illustrated washing machine according to the invention and
- Fig. 2: a switching circuit according to the invention for the washing machine.

### Detailed description of the embodiments

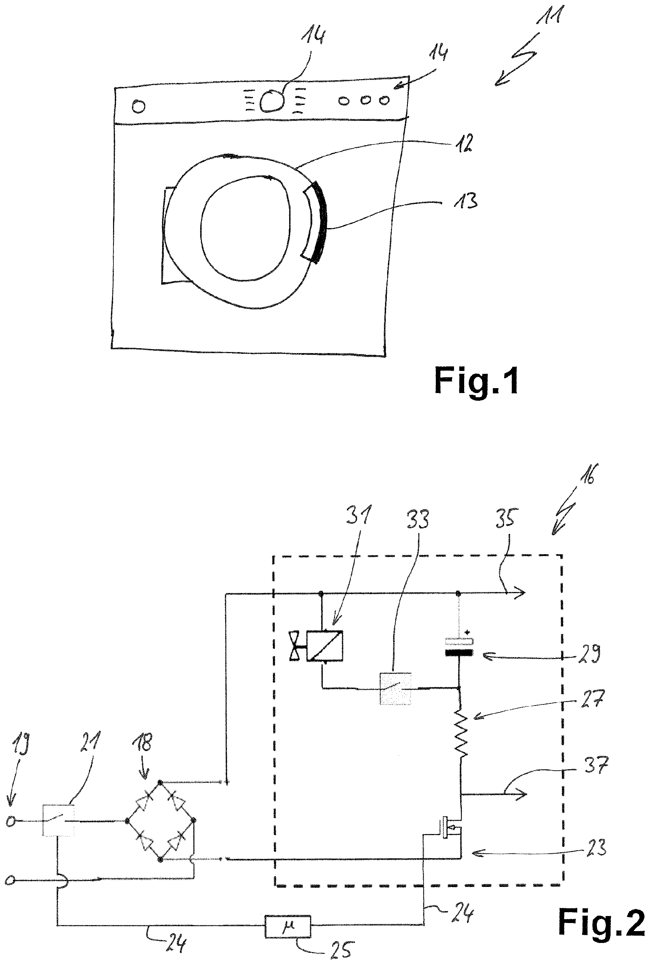

In Fig. 1, a washing machine 11 according to the invention is illustrated having a conventional door 12 for access to a washing drum inside washing machine 11. The door 12 may have a door handle 13 which is hingedly fixed to the door 12 for opening the door 12. In an alternative embodiment, door handle 13 is affixed and one of operating elements 14 of the washing machine 11 may be a push button or a sensor switch which, upon actuation, unlocks the door 12 so that the door 12 can be easily opened. The unlocking of the door 12, either by the door handle 13 or by an operating element 14, may be blocked or prevented by the above-mentioned actuator or solenoid means, respectively. The exact mechanism needs not be described in here as it is basically known to a person skilled in the art and can easily be constructed in detail.

In Fig. 2 a switching circuit 16 according to the invention for a door opener of washing machine 11 as electrical appliance with the door 12 of Fig. 1 is illustrated. The switching circuit 16 comprises a DC voltage converter 18 connected to an AC mains 19 of the washing machine 11. There also is provided a first switching means 21 being constructed as a mechanical switch on the one hand, which is closed only when the drum is not in rotation. It can be a relay, a triac or a transistor. It only needs to be able to perform a switching operation.

An output of DC voltage converter 18 is connected on the negative side to a second switching means 23. The second switching means 23 may advantageously be a semiconductor switching means such as a transistor or a MOSFET. Both switching means 21 and 23 may be connected by a bus system 24 to a control 25. Control 25 can be a control only for switching circuit 16, but can also be a control for the whole washing machine 11, preferably made up by a microcontroller.

A series circuit connected to the output of DC voltage converter 18 and to the second switching means 23 also comprises a resistor 27 and a capacitor 29. The resistor 27 may have a value of 10 kΩ and the capacitor 29 may have a capacitance of 82 µF.

In parallel to the capacitor 29 a solenoid means 31 is provided in series with a voltage-controlled switch 33. Both parts are known for a person skilled in the art and, consequently, need not be described in further detail. The solenoid means 31 basically cooperate with an actuator and serve to unlock the door 12 of the washing machine 11 when energized. This means that usually a coil of the solenoid means 31 is energized, which again moves a plunger inside the coil to either unlock the door 12 directly or to establish a mechanical connection of for example the door handle 13 to a door locking mechanism.

The voltage-controlled switch 33 is of a kind that performs its switching action if a certain defined voltage is exceeded. This voltage can be for example more than 200 VDC, for example 210 VDC or 220 VDC.

If the switching circuit 16 is connected to a regular AC mains 19 in a household with 230 VAC and with the aforementioned values for the resistor 27 and the capacitor 29, if the first switching means 21 and the second switching means 23 are closed, it takes about 3 seconds to charge the capacitor 29 across resistor 27 up to a voltage of 210 VDC. This voltage of 210 VDC is also applied to the voltage-controlled switch 33 and corresponds to its activation voltage. Voltage-controlled switch 33 will close and thus the capacitor 29 discharges in a short high energy pulse of 0.25 seconds into the solenoid means 31. This discharge pulse is sufficient for activating the solenoid means 31 in a defined way. It can be seen that the solenoid means 31 are protected by resistor 27 against the full impact of the output of DC voltage converter 18 for long activation times. Furthermore, the AC mains 19 do not suffer inrush current variation when the solenoid means 31 are energized or activated, respectively.

It can be seen from Fig. 2 that, if the first switching means 21 are not closed or activated, respectively, DC voltage converter 18 is not even energized and, consequently, there is no chance for the solenoid means 31 to be activated. This is an advantageous location of the first switching means 21, but they could also be provided after the DC voltage converter 18.

A first feedback signal 35 is output between the capacitor 29 and the solenoid means 31. A second feedback signal 37 is provided between the second switching means 23 and the resistor 27. Both feedback signals 35 and 37 may be given to the control 25 via the bus system 24. The feedback signals 35 and 37 serve to prevent an accidental activation of the first switching means 21 or the second switching means 23. In general, if one of the switching means fails then the control can detect this and go to safe state. This provides for a double security and a second failure is then no more possible. The feedback signals can in any way also be provided at different locations.

## Claims

1. Electrical appliance (11) with a door (12), a door opener and a switching circuit (16) for the door opener, wherein the switching circuit comprises:
- a solenoid means (31) for mechanically opening or unlocking the door (12),
- a DC voltage converter (18) coupled to an AC mains (19),
- a first switching means (21) and a second switching means (23) for preventing or triggering actuation of the solenoid means (31),
- a series circuit of a capacitor (29), a resistor (27) and the second switching means (23) connected to an output of the DC voltage converter (18),
- in parallel to the capacitor (29) a series circuit of the solenoid means (31) and a voltage controlled switch (33) is provided, wherein the voltage controlled switch (33) is controlled by a voltage across the capacitor (29).

2. Electrical appliance (11) according to claim 1, wherein a signal output for a first feedback signal (35) to a control (25) of the electrical appliance (11) is provided between the solenoid means (31) and the capacitor (29).

3. Electrical appliance (11) according to claim 1 or 2, wherein a signal output for a second feedback signal (37) to a control (25) of the electrical appliance (11) is provided between the second switching means (23) and the resistor (27).

4. Electrical appliance (11) according to one of the preceding claims, wherein a first switching means (21) is provided before the DC voltage converter (18).

5. Electrical appliance (11) according to one of the preceding claims, wherein the capacity of the capacitor (29) and the resistance of the resistor (27) are chosen such that the charging time for charging the capacitor (29) up to a voltage that corresponds to the activating voltage of the voltage controlled switch (33) is between 2 seconds and 20 seconds.

6. Electrical appliance (11) according to one of the preceding claims, wherein the resistance of the resistor (27) is calculated as to block the energization of the solenoid means (31) if the voltage controlled switch (33) is short-cut taking into consideration the impedance of the solenoid means.

7. Electrical appliance (11) according to one of the preceding claims, wherein a duration of the pulse discharge of the capacitor (29) to the solenoid means (31) is between 0.1 seconds and 1 second, preferably between 0.2 seconds and 0.4 seconds.

8. Electrical appliance (11) according to one of the preceding claims, wherein the switching means (21, 23) are connected with a bus (24) of a control (25) of the electrical appliance (11).

9. Electrical appliance (11) according claim 8, wherein the feedback signals (35, 37) according to one of the claims 2 or 3 are provided and are connected with the bus (24).

## Patentansprüche

1. Elektrisches Gerät (11) mit einer Tür (12), einem Türöffner und einem Schaltkreis (16) für den Türöffner, wobei der Schaltkreis umfasst:
- ein Solenoidmittel (31) zum mechanischen Öffnen oder Entriegeln der Tür (12),
- einen mit einer Wechselstromnetzleitung (19) gekoppelten Gleichspannungswandler (18),
- ein erstes Schaltmittel (21) und ein zweites Schaltmittel (23) zum Verhindern oder Auslösen einer Betätigung des Solenoidmittels (31),
- eine serielle Schaltung von einem Kondensator (29), einem Widerstand (27) und dem zweiten Schaltmittel (23) verbunden mit einem Ausgang des Gleichspannungswandlers (18),
- parallel zum Kondensator (29) ist eine serielle Schaltung vom Solenoidmittel (31) und einem spannungsgesteuerten Schalter (33) vorgesehen, wobei der spannungsgesteuerte Schalter (33) durch eine Spannung über den Kondensator (29) gesteuert wird.

2. Elektrisches Gerät (11) nach Anspruch 1, wobei ein Signalausgang für ein erstes Feedbacksignal (35) zu einer Steuerung (25) des elektrischen Geräts (11) zwischen dem Solenoidmittel (31) und dem Kondensator (29) vorgesehen ist.

3. Elektrisches Gerät (11) nach Anspruch 1 oder 2, wobei ein Signalausgang für ein zweites Feedbacksignal (37) zu einer Steuerung (25) des elektrischen Geräts (11) zwischen dem zweiten Schaltmittel (23) und dem Widerstand (27) vorgesehen ist.

4. Elektrisches Gerät (11) nach einem der vorhergehenden Ansprüche, wobei ein erstes Schaltmittel (21) vor dem Gleichspannungswandler (18) vorgesehen ist.

5. Elektrisches Gerät (11) nach einem der vorhergehenden Ansprüche, wobei die Kapazität des Kondensators (29) und der Widerstand des Widerstands (27) derart gewählt sind, dass die Ladezeit zum Aufladen des Kondensators (29) auf eine Spannung, die der Aktivierungsspannung des spannungsgesteuerten Schalters (33) entspricht, zwischen 2 Sekunden und 20 Sekunden beträgt.

6. Elektrisches Gerät (11) nach einem der vorhergehenden Ansprüche, wobei der Widerstand des Widerstands (27) so berechnet ist, dass die Energiezufuhr des Solenoidmittels (31) gesperrt ist, wenn der spannungsgesteuerte Schalter (33) kurzgeschlossen ist, wobei die Impedanz des Solenoidmittels berücksichtigt ist.

7. Elektrisches Gerät (11) nach einem der vorhergehenden Ansprüche, wobei eine Dauer der Pulsentladung des Kondensators (29) zum Solenoidmittel (31) zwischen 0,1 Sekunden und 1 Sekunde liegt, bevorzugt zwischen 0,2 Sekunden und 0,4 Sekunden liegt.

8. Elektrisches Gerät (11) nach einem der vorhergehenden Ansprüche, wobei die Schaltmittel (21, 23) mit einem Bus (24) einer Steuerung (25) des elektrischen Geräts (11) verbunden sind.

9. Elektrisches Gerät (11) nach Anspruch 8, wobei die Feedbacksignale (35, 37) nach einem der Ansprüche 2 oder 3 vorgesehen sind und mit dem Bus (24) verbunden sind.

## Revendications

1. Appareil électrique (11) avec une porte (12), un dispositif d'ouverture de porte et un circuit de commutation (16) pour le dispositif d'ouverture de porte, le circuit de commutation comprenant :
- un moyen formant solénoïde (31) pour ouvrir ou déverrouiller la porte (12) mécaniquement,
- un convertisseur de tension CC (18) couplé à un réseau CA (19),
- un premier moyen de commutation (21) et un deuxième moyen de commutation (23) pour empêcher ou déclencher un actionnement du moyen formant solénoïde (31),
- un montage en série d'un condensateur (29), d'une résistance (27) et du deuxième moyen de commutation (23) connecté à une sortie du convertisseur de tension CC (18),
- un montage en série du moyen formant solénoïde (31) et d'un commutateur commandé en tension (33) étant prévu en parallèle au condensateur (29), dans lequel le commutateur commandé en tension (33) est commandé par une tension aux bornes du condensateur (29).

2. Appareil électrique (11) selon la revendication 1, dans lequel un signal émis pour un premier signal de rétroaction (35) à un élément de commande (25) de l'appareil électrique (11) est prévu entre le moyen formant solénoïde (31) et le condensateur (29).

3. Appareil électrique (11) selon la revendication 1 ou 2, dans lequel un signal émis pour un deuxième signal de rétroaction (37) à un élément de commande (25) de l'appareil électrique (11) est prévu entre le deuxième moyen de commutation (23) et la résistance (27).

4. Appareil électrique (11) selon l'une quelconque des revendications précédentes, dans lequel un premier moyen de commutation (21) est prévu avant le convertisseur de tension CC (18).

5. Appareil électrique (11) selon l'une quelconque des revendications précédentes, dans lequel la capacité du condensateur (29) et la valeur de résistance de la résistance (27) sont choisies de telle sorte que le temps de charge pour charger le condensateur (29) jusqu'à une tension qui correspond à la tension d'activation du commutateur commandé en tension (33) est compris entre 2 secondes et 20 secondes.

6. Appareil électrique (11) selon l'une quelconque des revendications précédentes, dans lequel la valeur de résistance de la résistance (27) est calculée de façon à bloquer l'excitation du moyen formant solénoïde (31) si le commutateur commandé en tension (33) est court-circuité en prenant en considération l'impédance du moyen formant solénoïde.

7. Appareil électrique (11) selon l'une quelconque des revendications précédentes, dans lequel une durée de la décharge d'impulsion du condensateur (29) vers le moyen formant solénoïde (31) est comprise entre 0,1 seconde et 1 seconde, de préférence entre 0,2 seconde et 0,4 seconde.

8. Appareil électrique (11), selon l'une quelconque des revendications précédentes, dans lequel le moyen de commutation (21, 23) est connecté à un bus (24) d'un élément de commande (25) de l'appareil électrique (11).

9. Appareil électrique (11) selon la revendication 8, dans lequel les signaux de rétroaction (35, 37) selon l'une quelconque des revendications 2 et 3 sont fournis et sont connectés au bus (24).
